# EUROPEAN PATENT APPLICATION

(11) **EP 2 105 950 A1**
(43) Date of publication of application: **30.09.2009**
(21) Application number: 08103000.9
(22) Date of filing: 27.03.2008
(51) Int. Cl.: H01L 21/027

(54) **Thin film etching method**

(71) Applicant: United Radiant Technology Corp., Taichung, Province of China (TW)
(72) Inventor: Wang, Pei-Chang, Jiaren Village, Tanzi Shiang, Taichung C (TW)
(74) Representative: Kewitz, Ansgar

(57) **Abstract**

A thin film etching method includes at least the steps (S1 to S6) of: projecting a ultraviolet light to expose an optical resin layer coated on a substrate (100) through a photo mask; heating the substrate to vaporize the exposed optical resin layer and retain the unexposed optical resin layer; forming a thin film to fill the vaporized portion of the optical resin layer; projecting the ultraviolet light to expose the entire optical resin layer; heating the substrate at a high temperature to vaporize the entire optical resin layer on the substrate to retain the thin film formed with a required graphic pattern. The method can be implemented at lower equipment and production costs and improve precision of the thin film etching.

## Description

### FIELD OF THE INVENTION

The present invention relates to a method for forming a graphic pattern on a thin film and particularly to a thin film etching method.

### BACKGROUND OF THE INVENTION

The conventional thin film etching methods generally can be divided into dry etching and wet etching. The dry etching method includes laser etching and printing etch paste. The laser etching technique etches a thin film by directly projecting a laser beam to remove unnecessary portions of the thin film to form a required graphic pattern. The printing etch paste approach forms an etch paste on the thin film by printing, then removes a selected portion of the thin film by heating through the etch paste to form the desired thin film with a required graphic pattern.

The wet etching method first forms a photoresist graphic pattern layer on a thin film that may be formed by printing, or transferring a graphic pattern through a photolithography and an etching processes; then a portion of the thin film without being protected by the photoresist layer is removed by exposing to a chemical solution to generate a chemical reaction to form a required graphic pattern on the thin film. The wet etching process is faster and simpler, but has problems such as disposing of waste solution and remanent chemical ingredients on the products that might affect the quality.

Basically, the dry etching method has benefits such as a lower production cost and equipment investment, and less impact to environment. But the precision of etching lines on the thin film is inferior to the wet etching process.

Therefore, how to develop an etching method for thin films that has the benefits of the dry etching method with a lower equipment and production cost, and less impact to the environment, and also has the benefits of the wet etching process of higher precision but without remanent chemical ingredients on the products is an issue hotly pursued in the industry.

### SUMMARY OF THE INVENTION

Therefore, the primary object of the present invention is to provide a thin film etching method that costs less in equipment investment and production, creates less impact to environments and achieves higher precision etching. The thin film etching method according to the invention does not use acid solution in the fabrication process, thus the equipment and production costs are lower than the wet etching process. It adopts photo exposure through a photo mask to form a desired graphic pattern, hence provides precision greater than the dry etching method and substantially as good as the wet etching process.

To achieve the foregoing object, the thin film etching method of the invention includes at least the steps of: providing a substrate coated evenly with an optical resin layer; projecting ultraviolet light to generate photo exposure on the optical resin layer through a photo mask; heating the substrate at a selected high temperature to vaporize the optical resin layer projected by the ultraviolet light and retain the unexposed portion such that a required graphic pattern is formed at the vaporized portion of the optical resin layer; forming a thin film on the surface of the substrate to cover the optical resin layer where vaporization occurred and the surface of the optical resin layer; projecting the entire surface of the optical resin layer with the ultraviolet light; heating the substrate at a selected high temperature to vaporize all the optical resin layer attached thereon, and removing the thin film attached with the optical resin layer to form the required graphic pattern on the thin film.

The thin film is formed by selecting one of the following processes: evaporation, sputtering, electron beam evaporation, chemical vapor deposition (CVD) and plasma enhanced CVD.

At the step of projecting the entire surface of the optical resin layer with the ultraviolet light, if the thin film is light penetrative, the ultraviolet light may be located above the thin film so that the entire optical resin layer can be exposed by the ultraviolet light passing through the thin film. In the event that the substrate is light penetrative the ultraviolet light may be located below the substrate so that the entire optical resin layer can be exposed by the ultraviolet light passing through the substrate.

The method of the invention provides many benefits, such as the process of forming the graphic pattern or circuits on the thin film on the substrate does not use acid solution, thus equipment and production costs are lower than the conventional wet etching process; the graphic pattern is formed by exposing through a photo mask, thus the precision of the graphic pattern lines is greater than the conventional dry etching method and substantially as good as the wet etching process. Therefore, it has the benefits of both the wet etching process and the dry etching method without remanent chemical ingredients on the products. A desired product quality can be achieved.

The foregoing, as well as additional objects, features and advantages of the invention will be more readily apparent from the following detailed description, which proceeds with reference to the accompanying drawings. The embodiments discussed below serve only for illustrative purpose and are not the limitation of the invention.

### BRIEF DESCRIPTION OF THE DRAWINGS

- FIG. 1: is a schematic view of an embodiment of the substrate of the invention evenly coated with an optical resin layer.
- FIG. 2: is a schematic view of an embodiment of the invention with the optical resin layer exposed through a photo mask.
- FIG. 3: is a schematic view of an embodiment of the invention with the unexposed optical resin layer retained by a heating process.
- FIG. 4: is a schematic view of an embodiment of the invention for forming a thin film on the substrate by sputtering.
- FIG. 5: is a schematic view of an embodiment of the invention with the entire optical resin layer exposed by ultraviolet light.
- FIG. 6: is a schematic view of an embodiment of the invention with the optical resin layer vaporized through a heating process to form a required thin film graphic pattern.
- FIG. 7: is a schematic view of another embodiment of the invention with the entire optical resin layer exposed by the ultraviolet light.
- FIG. 8: is a schematic flowchart showing the principle steps of the disclosed method(s).

### DETAILED DESCRIPTION OF THE PREFERRED EMBODIMENTS

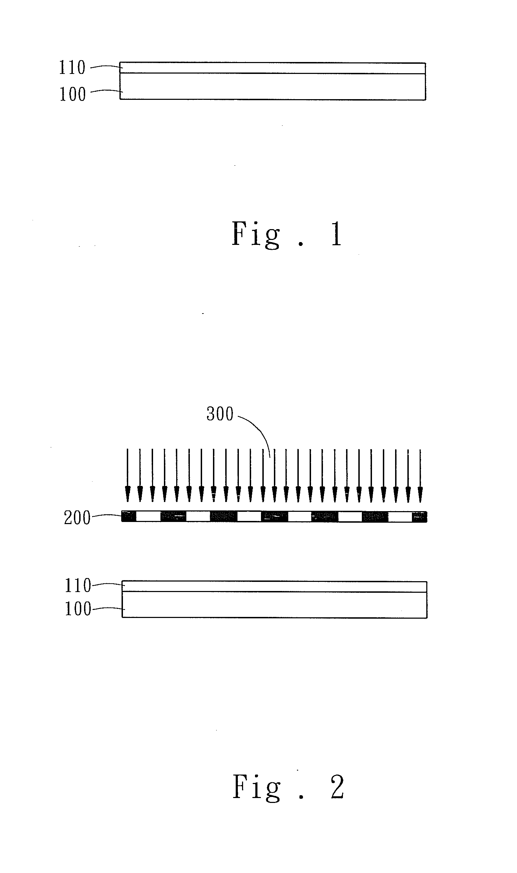

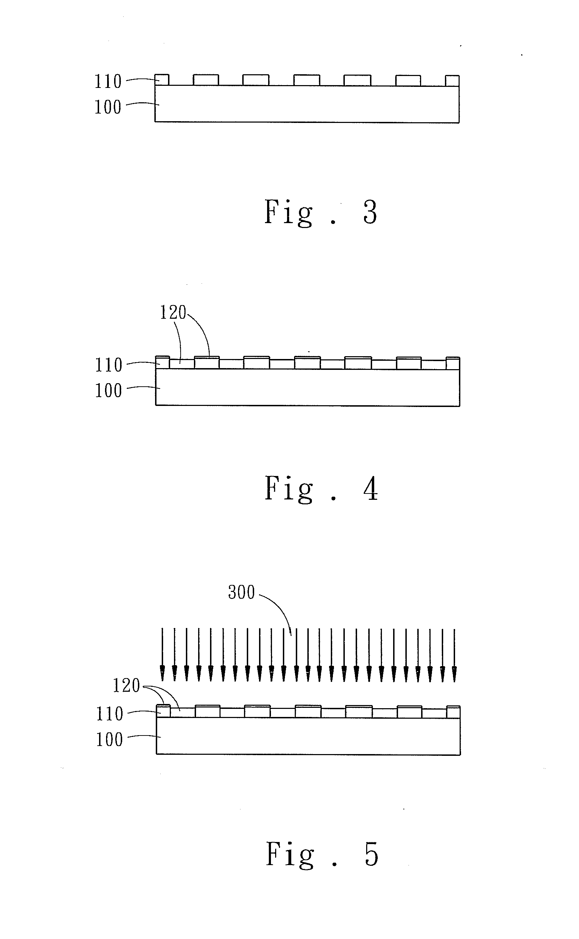

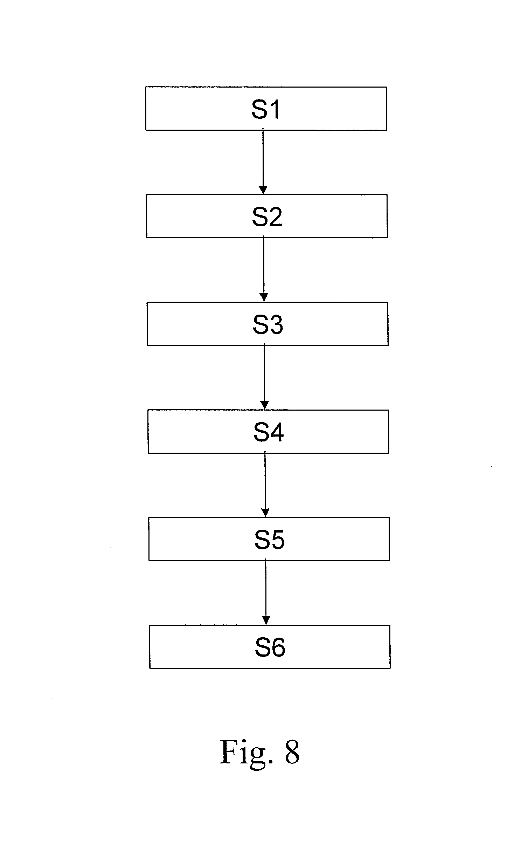

Please refer to FIGS. 1 through 6 for an embodiment of the invention. The thin film etching method according to the invention includes at least the following steps (also see Fig. 8 with steps S1 to S6): providing in step S1 a substrate 100 coated evenly thereon an optical resin layer 110 (as shown in FIG. 1); projecting in step S2 a ultraviolet light 300 onto the optical resin layer 110 through a light penetrative portion of a photo mask 200 to generate photo exposure (referring to FIG. 2); heating in step S3 the substrate 100 at a selected high temperature such as 200 - 350 °C to vaporize the optical resin layer 110 received projection of the ultraviolet light 300 to remove the projected optical resin layer and expose the surface of the substrate 100 thereof; retaining the unexposed optical resin layer 110 and forming a required graphic pattern where the optical resin layer 110 has been vaporized (referring to FIG. 3); sputtering on the substrate 100 where the optical resin layer 110 is formed with the graphic pattern to form in step S4 a thin film 120 to fill the vaporized portion and also adhere to the surface of the optical resin layer 110 (referring to FIG. 4). Aside from sputtering, the thin film 120 may also be formed by evaporation, electron beam evaporation, chemical vapor deposition (CVD) or plasma enhanced CVD.

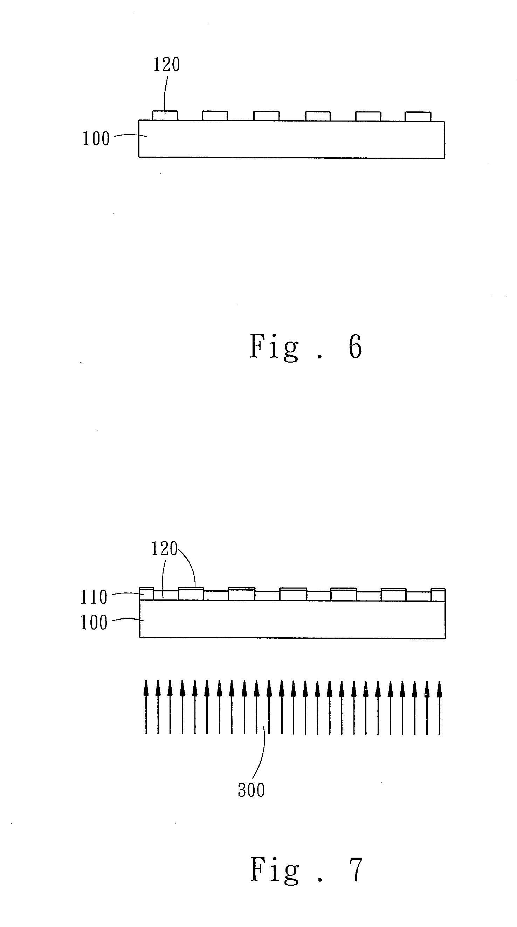

Then the entire optical resin layer 110 is exposed in step S5 by the ultraviolet light 300 (referring to FIG. 5); heat in step S6 the substrate 100 at a selected high temperature such as 200 - 350 °C to vaporize all the optical resin layer 110 adhered to the substrate 100; remove the optical resin layer 110 and also the thin film 120 adhered to the surface of the optical resin layer 110 with only the thin film 120 attached to the surface of the substrate 100 being retained with the required graphic pattern formed thereon (referring to FIG. 6).

At the step of exposing the entire optical resin layer 110 with the ultraviolet light 300, if the thin film 120 is light penetrative such as a transparent conductive film, the ultraviolet light 300 may be disposed above the thin film 120 to pass through the thin film 120 to expose the entire optical resin layer 110, then the substrate 100 is heated to vaporize the optical resin layer 110 attached thereon to remove the entire optical resin layer 110 (referring to FIG. 5).

Referring to FIG. 7, if the substrate 100 is light penetrative, such as a glass substrate, the ultraviolet light 300 may be located below the substrate 100 to pass through the substrate 100 to expose the entire optical resin layer 110, then the substrate 100 is heated to vaporize the optical resin layer 110 attached thereon to remove the entire optical resin layer 110.

In summary a thin film etching method is disclosed including the steps of: projecting a ultraviolet light to expose an optical resin layer coated on a substrate through a photo mask; heating the substrate to vaporize the exposed optical resin layer and retain the unexposed optical resin layer; forming a thin film to fill the vaporized portion of the optical resin layer; projecting the ultraviolet light to expose the entire optical resin layer; heating the substrate at a high temperature to vaporize the entire optical resin layer on the substrate to retain the thin film formed with a required graphic pattern. The method can be implemented at lower equipment and production costs and improve precision of the thin film etching.

While the preferred embodiments of the invention have been set forth for the purpose of disclosure, modifications of the disclosed embodiments of the invention as well as other embodiments thereof may occur to those skilled in the art. Accordingly, the appended claims are intended to cover all embodiments which do not depart from the spirit and scope of the invention.

## Claims

1. A thin film etching method, comprising at least:
providing (S1) a substrate (100) evenly coated with an optical resin layer (110);
projecting (S2) a ultraviolet light (300) onto the optical resin layer (110) through a photo mask (200)to expose a portion thereof;
heating (S3) the substrate (100) to vaporize the portion of the optical resin layer (110) received the projection of the ultraviolet light (300) and retain the other portion of the optical resin layer (110) that is unexposed;
forming (S4) a thin film on the surface of the substrate (100) to fill the vaporized optical resin layer (110) and the surface of the optical resin layer (110);
projecting (S5) the ultraviolet light (300) onto the entire optical resin layer (110); and
heating (S6) the substrate (100) to vaporize the optical resin layer (110) attached to the substrate (100) and remove the thin film (120) adhered to the surface of the optical resin layer (110) to retain the thin film (120) formed with a required graphic pattern.

2. The thin film etching method of claim 1, wherein the thin film (120) is formed by a method selected from the group consisting of evaporation, sputtering, electron beam evaporation, chemical vapor deposition (CVD) and plasma enhanced CVD.

3. The thin film etching method of claim 1, wherein the thin film (120) is light penetrative and the ultraviolet light passes through the thin film to expose the entire optical resin layer (110).

4. The thin film etching method of claim 1, wherein the substrate (100) is light penetrative and the ultraviolet light (300) passes through the substrate (100) to expose the entire optical resin layer (110).
